# EUROPÄISCHE PATENTSCHRIFT

(11) **EP 1 705 727 B1**
(45) Veröffentlichungstag und Bekanntmachung des Hinweises auf die Patenterteilung: **26.12.2007**
(21) Anmeldenummer: 05005573.0
(22) Anmeldetag: 15.03.2005
(51) Int. Cl.: H01L 51/50

(54) **Lichtemittierendes Bauelement**
Light emitting element
Elément émetteur de lumière

(43) Veröffentlichungstag der Anmeldung: 27.09.2006
(73) Patentinhaber: Novaled AG, 01307 Dresden (DE)
(72) Erfinder: Pfeiffer, Dr. Martin, 01139 Dresden (DE); Schwarz, Gregor, 01159 Dresden (DE); Murano, Dr. Sven, 01127 Dresden (DE); Birnstock, Dr. Jan, 01187 Dresden (DE)
(74) Vertreter: Bittner, Thomas L.

(56) Entgegenhaltungen:
- US-A1- 2003 042 848
- SEGAL ET AL: "EXCITONIC SINGLET-TRIPLET RATIOS IN MOLECULAR AND POLYMERIC ORGANIC MATERIALS" Bd. 68, 28. August 2003 (2003-08-28), Seiten 75211-14, XP009077558

## Beschreibung

Die Erfindung bezieht sich auf ein lichtemittierendes Bauelement, insbesondere eine organische Leuchtdiode (OLED), mit einer Elektrode und einer Gegenelektrode und einem zwischen der Elektrode und der Gegenelektrode angeordneten, organischen Bereich mit einem lichtemittierenden organischen Bereich, welcher eine Emissionsschicht und eine weitere Emissionsschicht umfasst und welcher, beim Anlegen einer elektrischen Spannung an die Elektrode und die Gegenelektrode, Licht in mehreren Farbbereichen im sichtbaren Spektralbereich emittierend gebildet ist, wahlweise bis hin zu Weißlicht.

### Stand der Technik

Organischen Leuchtdioden, welche Licht in mehreren Farbbereichen bis hin zu Weißlicht emittieren, wurde in den vergangenen Jahren verstärkt Aufmerksamkeit gewidmet. Es ist allgemein anerkannt, dass diese Technologie ein großes Potential für mögliche Anwendungen im Bereich der Beleuchtungstechnik besitzt. Mittlerweile erreichen weiße organische Leuchtdioden Leistungseffizienzen, welche im Bereich von konventionellen elektrischer Glühlampen liegen (vgl. Forrest et al., Adv. Mater. 7, 624 (2004)). Weitere Verbesserungen werden erwartet. Somit haben weiße OLEDs das Potential, eine bedeutende Alternative zu den momentan den Markt dominierenden Beleuchtungstechnologien, beispielsweise Glühlampen, Halogenlampen, Niederspannungsleuchtstoffröhren oder dergleichen zu bilden.

Generell lassen sich für OLEDs basierend auf niedermolekularen Substanzen ("small molecules") höhere Effizienzen erzielen, wenn phosphoreszierende Emitter verwendet werden. Diese können bis zu 100% der entstehenden Exzitonen nutzen, was einer internen Quantenausbeute von 100% entspricht, im Gegensatz zu fluoreszierenden Emittern, welche lediglich den 25% Anteil an Singulett-Exzitonen nutzen (vgl. Baldo et al., Nature 395, 151 (1998); Baldo et al., Appl. Phys. Lett. 75, 4 (1999)). Der Begriff phosphoreszierender Emitter bezeichnet ein Material, welches in der Lage ist, Phosphoreszenzlicht zu emittieren. In gleicher Weise bezeichnet der Begriff fluoreszierender Emitter ein Material, welches in der Lage ist, Fluoreszenzlicht abzugeben.

Nach dem heutigen Stand der Technik basieren weiße OLEDs mit den höchsten bekannten Effizienzen auf phosphoreszierenden Emittern (vgl. D'Andrade et al., Adv. Mater. 16, 624 (2004)).

Aus dem Dokument WO 02/091814 A2 ist ein organisches lichtemittierendes Bauelement bekannt, bei dem mehrere lichtemittierende Dotanden verwendet werden, wobei wenigstens ein Dotand einen phosphoreszierenden Emitter in einer oder mehreren dünnen emittierenden Filmschichten umfaßt. Die mehreren emittierenden Dotanden sind in einen lichtemittierenden Bereich eingebracht. Der lichtemittierende Bereich umfaßt ein Matrixmaterial und mehrere emittierende Dotanden, wobei der lichtemittierende Bereich mehrere Bänder aufweist und wobei jeder lichtemittierende Dotand in ein separates Band innerhalb des lichtemittierenden Bereiches dotiert ist. Wenigstens einer der lichtemittierenden Dotanden emittiert Licht mittels Phosphoreszenz.

Für einen Durchbruch von weißen OLEDs auf dem Beleuchtungsmarkt sind jedoch noch deutliche technische Verbesserungen von Nöten. Eine Herausforderung, die heute noch nicht befriedigend gelöst worden ist, ist die Realisierung von hocheffizienten, weißen OLEDs mit einer langen Lebensdauer. Dem Stand der Technik entsprechende Weißlichtquellen haben Lebensdauern von etwa 750h im Fall der Glühbirne bis zu 10.000h im Fall der Leuchtstoffröhre. In weißen OLEDs wird generell ein Beitrag von blauen oder zumindest blaugrünen Emittern benötigt. Die Langzeitstabilität blauer Phosphoreszenzemitter ist jedoch extrem begrenzt. Lange Lebensdauern blauer OLED-Emitter im Bereich einiger tausend bis zehntausend Stunden sind nur für fluoreszierende Emitter bekannt, welche jedoch nur maximal 25% der entstehenden Exzitonen zur Lichtgeneration nutzen können. Grüne und rote Phosphoreszenzemitter wiederum sind mit Lebensdauern im Bereich mehrerer zehntausend bis hunderttausend Stunden bekannt.

Tatsächlich gibt es bislang keine befriedigende Lösung für dieses Problem. Lebensdauern von weißen OLEDs, die auf blauen Triplett-Emittern basieren, sind zu niedrig, als dass sie für anwendungsfähige Produkte geeignet wären. Daher zielen momentan alle Ansätze, weiße OLEDs in die Produktion einzuführen, auf die Verwendung fluoreszierender blauer Emitter ab. Zwar sind bei diesen Ansätzen die Effizienzen gering, aber die Lebensdauer entspricht den Spezifikationen der Industrie, die im Bereich einiger 10.000h bei einigen 100cd/m² liegen. Als rote und grüne oder orange Emitter kommen sowohl phosphoreszierende als auch fluoreszierende Emitter in Frage, da für diese Farben die Lebensdauern der Triplett-Emitter bereits ausreichend hoch ist. Es gibt zahlreiche Ansätze weißes Licht zu generieren, zum Beispiel mittels Mischung von zwei Farben, beispielsweise die Farben Blaugrün und Orange, oder Mischung von drei Farben, beispielsweise die Farben Rot, Grün und Blau. Die Mischung wiederum kann auf verschiedene Weisen erfolgen, zum Beispiel mittels:
- Stapeln der verschiedenfarbig emittierenden OLEDs übereinander,
- Plazieren verschiedenfarbig emittierender OLEDs nebeneinander,
- Einbringen verschiedenfarbiger Emitter in dieselbe Emissionsschicht oder
- Einbringen der verschiedenfarbigen Emitter in verschiedene Emissionsschichten, die mit Hilfe von dünnen Zwischenschichten voneinander getrennt sein können.

### Die Erfindung

Der Erfindung liegt die Aufgabe zugrunde, ein verbessertes lichtemittierendes Bauelement der eingangs genannten Art zu schaffen, welches bei hoher Effizienz auch über eine für Beleuchtungszwecke ausreichende lange Lebensdauer verfügt.

Diese Aufgabe wird erfindungsgemäß durch ein lichtemittierendes Bauelement nach dem unabhängigen Anspruch 1 gelöst. Vorteilhafte Ausgestaltungen der Erfindung sind Gegenstand von abhängigen Unteransprüchen.

Erfindungsgemäß ist ein lichtemittierendes Bauelement, insbesondere organische Leuchtdiode, mit einer Elektrode und einer Gegenelektrode und einem zwischen der Elektrode und der Gegenelektrode angeordneten, organischen Bereich mit einem lichtemittierenden organischen Bereich geschaffen, welcher eine Emissionsschicht und eine weitere Emissionsschicht umfasst und welcher, beim Anlegen einer elektrischen Spannung an die Elektrode und die Gegenelektrode, Licht in mehreren Farbbereichen im sichtbaren Spektralbereich emittierend gebildet ist, wahlweise bis hin zu Weißlicht, wobei die Emissionsschicht einen überwiegend im blauen oder im blaugrünen Spektralbereich Licht emittierenden, fluoreszierenden Emitter umfasst; die weitere Emissionsschicht einen oder mehrere überwiegend im nicht-blauen Spektralbereich Licht emittierenden, phosphoreszierenden Emitter umfasst; eine Triplettenergie für ein Energieniveau eines Triplettzustandes des fluoreszierenden Emitters in der Emissionsschicht größer als eine Triplettenergie für ein Energieniveau eines Triplettzustandes des phosphoreszierenden Emitters in der weiteren Emissionsschicht ist; und der lichtemittierende organische Bereich einen mindestens 5%-igen Anteil von des erzeugten Lichtes im sichtbaren Spektralbereich als Fluoreszenzlicht von Singulettzuständen des fluoreszierenden Emitters in der Emissionsschicht abgebend gebildet ist, und wobei weiterhin die folgenden Merkmale vorgesehen sind:
- der lichtemittierende organische Bereich umfasst eine andere Emissionsschicht mit einem oder mehreren überwiegend im nicht-blauen Spektralbereich Licht emittierenden, phosphoreszierenden Emittern;
- die Emissionsschicht ist zwischen der weiteren Emissionsschicht und der anderen Emissionsschicht angeordnet;
- die Emissionsschicht weist ein ambipolares Transportverhalten auf;
- die Dicke der Emissionsschicht ist größer als die doppelte Diffusionslänge der Singulett-Exzitonen aber kleiner als die doppelte Diffusionslänge der Triplett-Exzitonen;
- die weitere Emissionsschicht ist elektronentransportierend, wobei ein Abstand zwischen einer der Kathode zugewandten Oberfläche der weiteren Emissionsschicht und einer der weiteren Emissionsschicht zugewandten Oberfläche der Kathode kleiner als ein Abstand zwischen einer der Kathode zugewandten Oberfläche der Emissionsschicht und einer der Emissionsschicht zugewandten Oberfläche der Kathode sowie ein Abstand zwischen einer der Kathode zugewandten Oberfläche der anderen Emissionsschicht und einer der anderen Emissionsschicht zugewandten Oberfläche der Kathode ist; und
- die andere Emissionsschicht ist löchertransportierend, wobei ein Abstand zwischen einer der Anode zugewandten Oberfläche der anderen Emissionsschicht und einer der anderen Emissionsschicht zugewandten Oberfläche der Anode kleiner als ein Abstand zwischen einer der Anode zugewandten Oberfläche der Emissionsschicht und einer der Emissionsschicht zugewandten Oberfläche der Anode sowie ein Abstand zwischen einer der Anode zugewandten Oberfläche der weiteren Emissionsschicht und einer der weiteren Emissionsschicht zugewandten Oberfläche der Anode ist.

Die Erfindung hat gegenüber dem Stand der Technik den Vorteil, dass ein hocheffizientes und zugleich langlebiges lichtemittierendes Bauelement für Licht in mehreren Farbbereichen im sichtbaren Spektralbereich bis hin zu Weißlicht geschaffen ist. Das Problem, dass blaue fluoreszierende Emitter zwar lange leben aber nicht sehr effizient sind, wird dadurch überwunden, dass Triplett-Exzitonen, die beim Anlegen der elektrischen Energie in dem überwiegend im blauen oder im blaugrünen Spektralbereich Licht emittierenden Emitter entstehen und die normalerweise nichtstrahlend zerfallen, insbesondere aufgrund der Gestaltung der Triplettenergie für das Energieniveau des Triplettzustandes des fluoreszierenden Emitters in der Emissionsschicht und der Triplettenergie für das Energieniveau des Triplettzustandes des phosphoreszierenden Emitters in der weiteren Emissionsschicht zur Lichtemission genutzt werden. Auf diese Weise kann die Energie aus dem Triplettzustand des fluoreszierenden Emitters in der Emissionsschicht auf den Triplettzustand des phosphoreszierenden Emitters in der weiteren Emissionsschicht übertragen werden. Gleichzeitig erfolgt eine Lichtemission im blauen oder blaugrünen Spektralbereich beim Zerfall der Singulettzustände des fluoreszierenden Emitters in der Emissionsschicht. In dem organischen lichtemittierenden Bereich des Bauelementes laufen insbesondere die folgenden Prozesse ab:
a) die überwiegende Mehrheit der beim Zuführen der elektrischen Energie in dem Bauelement in dem organischen lichtemittierenden Bereich gebildeten Exzitonen wird auf dem fluoreszierenden Emitter in der Emissionsschicht in Form von Singulett-Exzitonen und Triplett-Exzitonen gebildet;
b) ein Teil der Singulett-Exzitonen zerfällt strahlend unter Aussendung von blauem oder blaugrünem Fluoreszenzlicht;
c) die Triplett-Exzitonen diffundieren mittels Anregungsenergietransfer aus der Emissionsschicht in die weitere Emissionsschicht, welche den phosphoreszierenden Emitter enthält; und
d) die Triplett-Exzitonen des phosphoreszierenden Emitters zerfallen strahlend unter Aussendung von nicht-blauem Phosphoreszenzlicht.

Auf diese Weise wird die dem zwischen der Elektrode und der Gegenelektrode angeordneten, organischen Bereich zugeführte Energie mit hoher Effizienz zum Erzeugen von Licht mit unterschiedlichen Wellenlängen im sichtbaren Spektralbereich umgesetzt.

Ein wesentlicher Aspekt ist also die Kombination von langlebigen Emittermaterialien mit hocheffizienten Emittermaterialien. Wie bereits erwähnt, basiert eine weiß emittierende OLED stets darauf, dass ein oder mehrere blau oder blaugrün emittierende(r) Emitter implementiert ist / sind. Als Emitter wird hier ein fluoreszierendes Emittermaterial verwendet, da die Lebensdauern von phosphoreszierenden blauen oder blaugrünen Emittern für praktisch alle denkbaren Anwendungen um Größenordnungen zu niedrig sind. Mit fluoreszierenden blauen Emittern werden hingegen heute schon Lebensdauern von über 20.000h bei einer Helligkeit von 1000cd/m² erreicht. Anders ist die Situation bei roten und grünen Emittern. Hier werden tatsächlich auch mit phosphoreszierenden Emittern schon hohe Lebensdauern erzielt, zum Beispiel 30.000h bei einer Helligkeit von 500cd/m² für rote OLEDs. Die Erfindung ermöglicht es, trotz Nutzung eines fluoreszierenden blauen Emitters auch den Großteil, beispielsweise etwa 80 bis 90%, der in der blau emittierenden Emissionsschicht entstandenen Triplett-Exzitonen zur Lichterzeugung zu nutzen und so die Stromeffizienz des Bauelementes um einen Faktor 1.5 bis 2 zu erhöhen.

Bei einer zweckmäßigen Weiterbildung der Erfindung ist vorgesehen, dass zwischen der Emissionsschicht und der Kathode eine Löcherblockschicht angeordnet ist, wobei die Löcherblockschicht elektronentransportierend ist und ein organisches Material der Löcherblockschicht ein HOMO-Niveau aufweist, welches um wenigstens etwa 0.3eV tiefer liegt als ein HOMO-Niveau des fluoreszierenden Emitters in der Emissionsschicht.

Eine zweckmäßige Fortbildung der Erfindung kann vorsehen, dass zwischen der Emissionsschicht und der Anode eine Elektronenblockschicht angeordnet ist, wobei die Elektronenblockschicht löchertransportierend ist und ein organisches Material der Elektronenblockschicht ein LUMO-Niveau aufweist, welches um wenigstens etwa 0.3eV höher liegt als ein LUMO-Niveau des fluoreszierenden Emitters in der Emissionsschicht.

Bevorzugt sieht eine Ausführungsform der Erfindung vor, dass die Emissionsschicht und / oder die weitere Emissionsschicht und / oder die andere Emissionsschicht mehrschichtig gebildet sind.

Eine vorteilhafte Weiterbildung der Erfindung sieht vor, dass die Emissionsschicht eine Dicke zwischen etwa 5nm und etwa 50nm aufweist.

Eine zweckmäßige Weiterbildung der Erfindung kann vorsehen, dass der lichtemittierende organische Bereich Weißlicht emittierend gebildet ist, wobei der oder alle phosphoreszierenden Emitter in der weiteren Emissionsschicht im roten, orangen oder im gelben Spektralbereich Licht emittierende Emitter sind.

Bei einer bevorzugten Ausführungsform der Erfindung ist vorgesehen, dass der lichtemittierende organische Bereich Weißlicht emittierend gebildet ist, wobei der oder alle phosphoreszierenden Emitter in der weiteren Emissionsschicht im roten, im orangen oder im grünen Spektralbereich Licht emittierende Emitter sind.

Eine vorteilhafte Ausgestaltung der Erfindung sieht vor, dass der lichtemittierende organische Bereich Weißlicht emittierend gebildet ist, wobei der oder alle phosphoreszierenden Emitter in der anderen Emissionsschicht im roten, im orangen oder im gelben Spektralbereich Licht emittierende Emitter sind.

Zweckmäßig ist in einer Weiterbildung der Erfindung vorgesehen, dass der lichtemittierende organische Bereich Weißlicht emittierend gebildet ist, wobei der oder alle phosphoreszierenden Emitter in der anderen Emissionsschicht im roten, im orangen oder im grünen Spektralbereich Licht emittierende Emitter sind.

Eine zweckmäßige Weiterbildung der Erfindung sieht vor, dass der fluoreszierende Emitter in der Emissionsschicht eine metall-organische Verbindung oder eine Komplexverbindung mit einem Metall mit einer Ordnungszahl kleiner als 40 ist.

Eine bevorzugte Weiterbildung der Erfindung kann vorsehen, dass der fluoreszierende Emitter in der Emissionsschicht einen elektronenziehenden Substituenten aus einer der folgenden Klassen umfasst:
a) Halogene wie Fluor, Chlor, Iod oder Brom;
b) CN;
c) halogenierte oder cyanosubstituierte Alkane oder Alkene, insbesondere Trifluormethyl, Pentafluorethyl, Cyanovinyl, Dicyanovinyl, Tricyanovinyl;
d) halogenierte oder cyanosubstituierte Arylreste, insbesondere Pentafluorphenyl; oder
e) Borylreste, insbesondere Dialkyl-boryl, Dialkyl-boryl mit Substituenten an den Alkylgruppen, Diaryl-boryl oder Diaryl-boryl mit Substituenten an den Arylgruppen.

Eine vorteilhafte Weiterbildung der Erfindung sieht vor, dass der fluoreszierende Emitter in der Emissionsschicht einen elektronenschiebenden Substituenten einer der folgenden Klassen umfasst:
a) Alkylreste wie Methyl, Ethyl, Tertiärbutyl, Isopropyl;
b) Alkoxyreste;
c) Arylreste mit oder ohne Substituenten am Aryl, insbesondere Tolyl und Mesithyl; oder
d) Aminogruppen, insbesondere NH2, Dialkylamin, Diarylamin und Diarylamin mit Substituenten am Aryl.

Zweckmäßig sieht eine Ausführungsform der Erfindung vor, dass der fluoreszierende Emitter in der Emissionsschicht (EML1) eine funktionale Gruppe mit einer Elektronen-Akzeptor-Eigenschaft aus einer der folgenden Klassen umfasst:
a) Oxadiazol
b) Triazol
c) Benzothiadiazole
d) Benzimidazole und N-Aryl-Benzimidazole
e) Bipyridin
f) Cyanovinyl
g) Quinoline
h) Quinoxaline
i) Triarylboryl
j) Silol-Einheiten, insbesondere Derivat-Gruppen von Silacyclopentadien
k) Cyclooctatetraen
l) Chinoide Strukturen und Ketone, incl. chinoide Thiophen-Derivate
m) Pyrazoline
n) Pentaaryl-Cyclopentadien
o) Benzothiadiazole
p) Oligo-Para-Phenyl mit elektronenziehenden Substituenten oder
q) Fluorene und Spiro-Bifluorene mit elektronenziehenden Substituenten.

Bei einer zweckmäßigen Weiterbildung der Erfindung ist vorgesehen, dass der fluoreszierende Emitter in der Emissionsschicht (EML1) eine funktionale Gruppe mit einer Elektronen-Akzeptor-Eigenschaft aus einer der folgenden Klassen umfasst:
a) Triarylamine
b) Oligo-Para-Phenyl oder Oligo-Meta-Phenyl
c) Carbazole
d) Fluoren oder Spiro-Bifluorene
e) Phenylen-Vinylen-Einheiten
f) Naphthalen
g) Anthrazen
h) Perylen
i) Pyren oder
j) Thiophen.

### Erläuterungsbeispiele und Ausführung der Erfindung

Die Erfindung wird im folgenden anhand von Beispielen unter Bezugnahme auf Figuren der Zeichnung näher erläutert. Hierbei zeigen:
- Fig. 1: eine schematische Darstellung einer Schichtanordnung einer organischen Leuchtdiode;
- Fig. 2: eine schematische Darstellung einer Schichtanordnung einer weiteren organischen Leuchtdiode;
- Fig. 3: eine schematische Darstellung einer Schichtanordnung einer organischen Leuchtdiode, bei der eine Hauptrekombinationszone nach einem ersten Erläuterungsbeispiel gezielt gebildet ist;
- Fig. 4: eine schematische Darstellung einer Schichtanordnung einer organischen Leuchtdiode, bei der die Hauptrekombinationszone nach einem zweiten Erläuterungsbeispiel gezielt gebildet ist;
- Fig. 5: eine schematische Darstellung einer Schichtanordnung einer organischen Leuchtdiode, bei der die Hauptrekombinationszone nach einer bevorzugten Ausführungsform der vorliegenden Erfindung gezielt gebildet ist;
- Fig. 6: ein CIE-Farbdiagramm;
- Fig. 7: ein Modellspektrum für ein im blauen Spektralbereich Licht emittierendes Emittermaterial;
- Fig. 8: ein Diagramm zum Vergleich des notwendigen blauen Emissionslichtes bei einer Weißlichterzeugung für unterschiedliche Lichtemissionen im grünen und roten Spektralbereich;
- Fig. 9: ein Elektrolumineszenzspektrum für eine organische Referenz-Leuchtdiode;
- Fig. 10: ein Elektrolumineszenzspektrum für eine erste organische Leuchtdiode;
- Fig. 11: ein Elektrolumineszenzspektrum für eine zweite organische Leuchtdiode; und
- Fig. 12: Strukturformeln für Moleküle eines Emittermaterials.

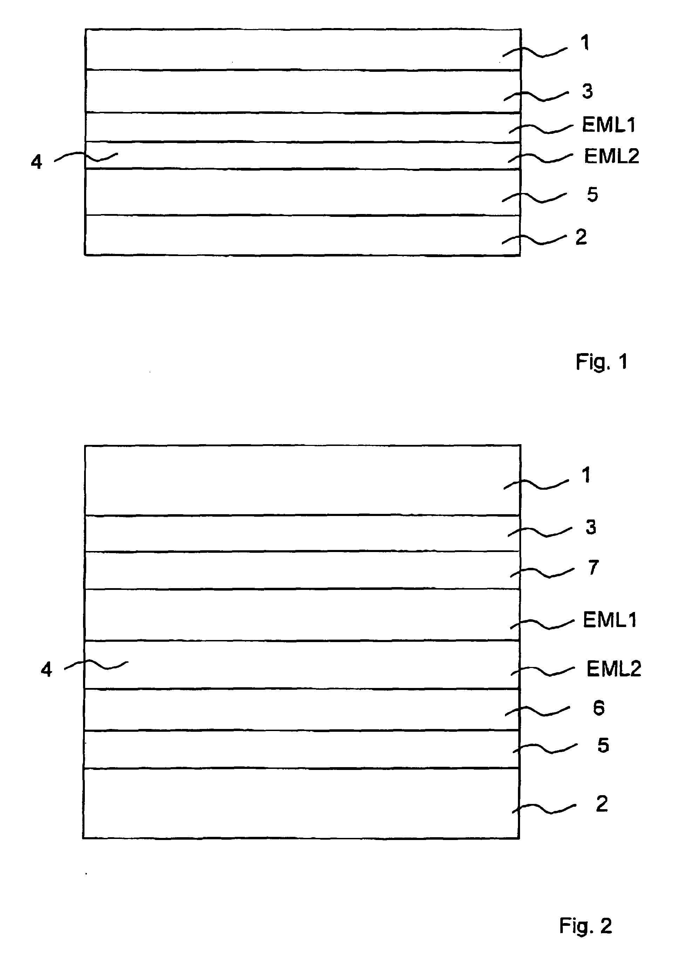

Fig. 1 zeigt eine schematische Darstellung einer Schichtanordnung einer organischen Leuchtdiode (OLED). Es sind zwei Elektroden, nämlich eine Anode 1 und eine Kathode 2, gebildet, zwischen denen ein organischer Bereich mit einer Löcher-Transportschicht 3 aus einer organischen Substanz dotiert mit einem Akzeptor-Material, einem organischen lichtemittierenden Bereich 4 mit einer Emissionsschicht EML1 und einer weiteren Emissionsschicht EML2 sowie einer Elektronen-Transportschicht 5 aus einer organischen Substanz dotiert mit einem Donor-Material angeordnet ist. Die Emissionsschicht EML1 umfasst einen überwiegend im blauen oder im blaugrünen Spektralbereich Licht emittierenden, fluoreszierenden Emitter. In einer alternativen Ausführungsform umfasst die Emissionsschicht EML1 mehrere überwiegend im blauen oder im blaugrünen Spektralbereich Licht emittierende, fluoreszierende Emitter. Die weitere Emissionsschicht EML2 umfasst einen oder mehrere überwiegend im nicht-blauen Spektralbereich Licht emittierende(n), phosphoreszierende(n) Emitter.

Fig. 2 zeigt eine schematische Darstellung einer Schichtanordnung einer weiteren OLED. Für gleiche Merkmale werden in Fig. 2 die gleichen Bezugszeichen wie in Fig. 1 verwendet. Im organischen Bereich sind bei der OLED in Fig. 2 zusätzlich eine Löcherblockschicht 6 und eine Elektronenblockschicht 7 vorgesehen.

Innerhalb der OLED laufen während des Betriebes folgende Prozesse ab:
- Ladungsträger in Form von Löchern werden durch die Anode 1 in die Löcher-Transportschicht 3 injiziert, wandern durch die Löcher-Transportschicht 3 hindurch und erreichen, gegebenenfalls durch die Elektronenblockschicht 7, den lichtemittierenden organischen Bereich 4;
- Ladungsträger in Form von Elektronen werden durch die Kathode 2 in die Elektronen-Transportschicht 5 injiziert, wandern durch die Elektronen-Transportschicht 5 hindurch und erreichen, gegebenenfalls durch die Löcherblockschicht 6 hindurch, den lichtemittierenden organischen Bereich 4; und
- in dem organischen lichtemittierenden Bereich 4 treffen Löcher und Elektronen aufeinander und rekombinieren zu angeregten Zuständen, so genannten Exzitonen, welche in Triplett- und Singulettzuständen gebildet werden.

Hinsichtlich ihrer Transport- oder Leiteigenschaften können die verwendeten organischen Materialien elektronenleitend / elektronentransportierend sein, wobei diese Materialien dann auch löcherleitend / löchertransportierend sein können. In gleicher Weise gilt, dass ein als löcherleitend / löchertransportierend bezeichnetes organisches Material auch elektronenleitend / elektronentransportierend sein kann, so das sich die beiden Eigenschaften nicht ausschließen.

Vorteilhaft ist es bei der Implementierung der Erfindung, wenn der energetische Abstand zwischen dem Singulettzustand und dem Triplettzustand des im blauen oder blaugrünen Spektralbereich emittierenden Emitters in der Emissionsschicht EML1 möglichst gering ist, so dass ein exothermer Energietransfer auf die Triplettzustände der im nicht-blauen Spektralbereich emittierenden Emitter in der weiteren Emissionsschicht EML 2 ermöglicht wird. Für den im blauen oder blaugrünen Spektralbereich emittierenden Emitter werden bevorzugt die folgenden Designprinzipien genutzt:
i) Das Emittermaterial ist eine metall-organische Verbindung oder eine Komplexverbindung, wobei der niedrigste Anregungszustand "metal-to-ligand-charge-transfer"-Charakter (MLCT) trägt, was bedeutet, dass bei der Anregung ein Elektron aus einem Orbital, das vorwiegend auf dem Metall lokalisiert ist, auf ein Orbital gehoben wird, das vorwiegend auf dem organischen Liganden lokalisiert ist.
ii) Das Emittermaterial ist push-pull-substituiert, was bedeutet, an ein Grundgerüst, über welches die pi-Elektronen der HOMO- und der LUMO-Wellenfunktion (HOMO - "Highest Occupied Molecular Orbital"; LUMO - "Lowest Unoccupied Molecular Orbital") delokalisiert sind, mindestens ein Substituent mit elektronenschiebendem Charakter und mindestens ein anderer Substituent mit elektronenziehendem Charakter angehängt werden, so dass der Schwerpunkt der HOMO-Wellenfunktion zu den elektronenschiebenden Substituenten hin verschoben wird und der Schwerpunkt der LUMO-Wellenfunktion zu den elektronenziehenden hin verschoben wird und sich die räumliche Überlappung von HOMO- und LUMO-Wellenfunktion damit im Vergleich zu einem entsprechenden Molekül ohne Substituenten oder einem mit ausschließlich elektronenziehenden oder ausschließlich elektronenschiebenden Substituenten reduziert.
iii) Das pi-Elektronensystem des Emittermaterials erstreckt sich über funktionelle Gruppen, die teilweise eher Elektronen-Akzeptor-Charakter tragen und auf die sich dementsprechend die LUMO-Wellenfunktion konzentriert, und andere funktionelle Gruppen, die eher Elektronen-Donor-Charakter tragen und auf die sich folglich die HOMO-Wellenfunktion konzentriert.

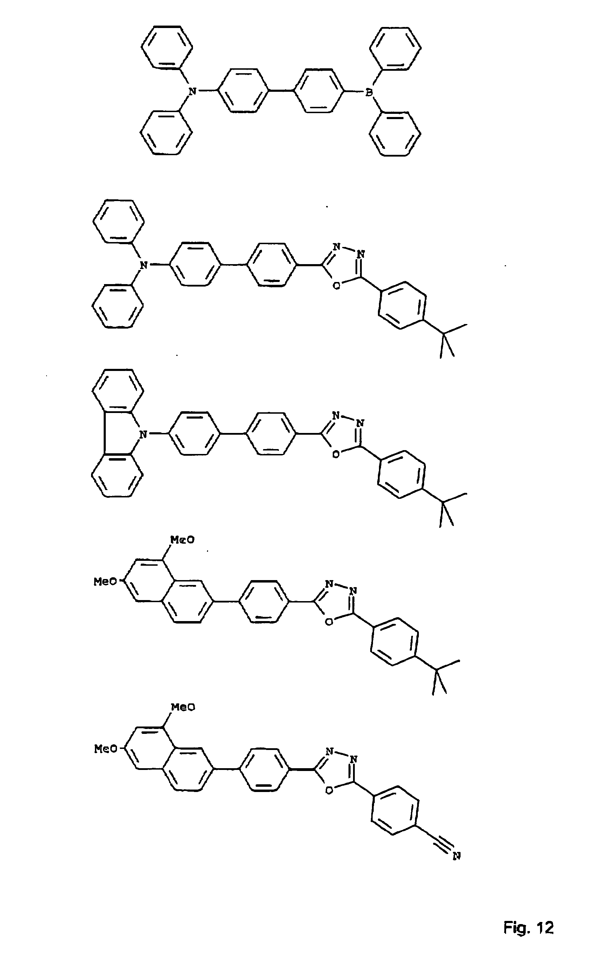

Fig. 12 zeigt Strukturformeln für Moleküle von im blauen oder blaugrünen Spektralbereich emittierenden Emittern, bei denen die vorgenannten Designregeln berücksichtigt sind.

Die OLEDs nach den Fig. 1 und 2 zeichnen sich dadurch aus, dass die Ladungsträgerrekombination zum überwiegenden Teil in der Emissionsschicht EML1 erfolgt, wodurch sich in der Emissionsschicht EML1 sowohl Triplett- als auch Singulett-Exzitonen bilden. Es wird die Lage einer Hauptrekombinationszone gezielt beeinflusst. Der Begriff Hauptrekombinationszone bezeichnet ein Raumgebiet innerhalb des Bereichs der organischen Schichten zwischen der Anode 1 und der Kathode 2, in dem mindestens etwa 50% der injizierten Ladungsträger rekombinieren.

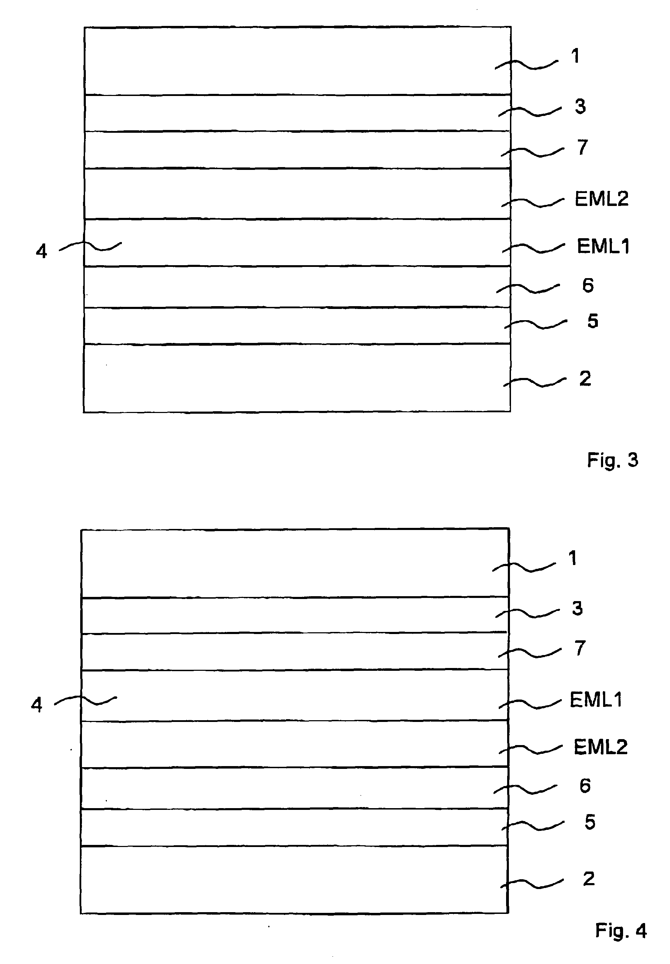

Im folgenden werden unter Bezugnahme auf die Fig. 3 bis 5 Erläuterungsbeispiele zur gezielten Beeinflussung der Hauptrekombinationszone beschrieben. Für gleiche Merkmale werden in den Fig. 3 bis 5 die gleichen Bezugszeichen wie in den Fig. 1 und 2 verwendet.

Die Beeinflussung der Lage der Hauptrekombinationszone erfolgt bei einer OLED nach Fig. 3 dadurch, dass die weitere Emissionsschicht EML2 als Ladungsträger bevorzugt Löcher transportiert, das heißt die weitere Emissionsschicht EML2 ist löcherleitend / -transportierend gebildet, und direkt benachbart zu der Elektronenblockschicht 7 oder, falls eine solche Schicht bei einer anderen Ausführungsform (nicht dargestellt) nicht vorhanden ist, direkt benachbart zu der Löcher-Transportschicht 3 angeordnet ist.

Die Emissionsschicht EML1 mit dem fluoreszierenden Emitter ist in diesem Falle in direkter Nachbarschaft zu der Löcherblockschicht 6 oder, falls diese Schicht nicht vorhanden ist, in direkter Nachbarschaft zur Elektronen-Transportschicht 5. Es ist bei diesem Beispiel darüber hinaus vorgesehen, dass auch die Emissionsschicht EML1 bevorzugt Löcher transportiert, das heißt die Emissionsschicht EML1 ist löcherleitend / -transportierend gebildet. Auf diesem Wege wird gewährleistet, dass die Löcher bevorzugt in der Nähe der Grenzfläche zwischen der Emissionsschicht EML1 und der Löcherblockschicht 6, oder, falls diese Schicht nicht vorgesehen ist, der Elektronen-Transportschicht 5 auf die Elektronen treffen und mit diesen unter Exzitonenbildung rekombinieren.

Obgleich sich die Hauptrekombinationszone in der Nähe dieser Grenzfläche befindet, findet die Rekombination fast ausschließlich in der Emissionsschicht EML1 statt, nicht in der angrenzenden Schicht. Eine solche Anordnung verhindert insbesondere, dass ein Elektronentransport tief in die Emissionsschichten EML1, EML2 hinein erfolgt, was eine Verbreiterung der Emissionszone zur Folge hätte oder im ungünstigsten Fall zu einer Rekombination der Elektronen und der Löcher in der weiteren Emissionsschicht EML2 führen könnte, was der beabsichtigten optimierten Weißlichterzeugung entgegenwirken würde.

Eine besonders vorteilhafte Ausgestaltung der Ausführung mit der Löcherblockschicht 6 sieht vor, dass eine minimale Energie von Singulett-Exzitonen und von Triplett-Exzitonen in der Löcherblockschicht 6 größer ist als eine minimale Energie von Singulett-Exzitonen und von Triplett-Exzitonen in der Emissionsschicht EML1. Hierdurch wird erreicht, dass die Triplett-Exzitonen, die in der Emissionsschicht EML1 entstehen, nur in Richtung der weiteren Emissionsschicht EML2 diffundieren können, wodurch sich die Effizienz der OLED erhöht. Ist keine Löcherblockschicht vorgesehen, gilt diese Anforderung an die Exzitonen-Energie für eine vorteilhafte Ausgestaltung der Erfindung sinngemäß für die Elektronentransportschicht.

Eine alternative Anordnung zur Kontrolle der Lage der Hauptrekombinationszone ist bei einer Ausführungsform einer OLED nach Fig. 4 dadurch realisiert, dass die weitere Emissionsschicht EML2 mit dem phosphoreszierenden Emitter als Ladungsträger bevorzugt Elektronen transportiert, das heißt die weitere Emissionsschicht EML2 ist elektronenleitend / -transportierend gebildet, und direkt benachbart zu der Löcherblockschicht 6 oder, falls eine solche Schicht bei einer anderen Ausführungsform (nicht dargestellt) nicht vorhanden ist, direkt benachbart zu der Elektronen-Transportschicht 5 angeordnet ist.

Die Emissionsschicht EML1 mit dem fluoreszierenden Emitter ist in diesem Falle in direkter Nachbarschaft zu der Elektronenblockschicht 7, oder falls diese Schicht nicht vorhanden ist, in direkter Nachbarschaft zur Löcher-Transportschicht 3. Es ist bei diesem Beispiel darüber hinaus vorgesehen, dass die Emissionsschicht EML1 als Ladungsträger bevorzugt Elektronen transportiert, das heißt die Emissionsschicht EML1 ist elektronenleitend /-transportierend gebildet. Hierdurch wird gewährleistet, dass die Elektronen bevorzugt in der Nähe der Grenzfläche zwischen der Emissionsschicht EML1 und der Elektronenblockschicht 7, oder falls diese Schicht nicht vorgesehen ist, der Löcher-Transportschicht 3 auf die Löcher treffen und mit diesen unter Exzitonenbildung kombinieren. Obgleich die Hauptrekombinationszone in der Nähe dieser Grenzfläche gebildet ist, findet die Rekombination fast ausschließlich in der Emissionsschicht EML1 statt, nicht in der angrenzenden Schicht. Eine solche Anordnung verhindert insbesondere, dass ein Transport von Löchern tief in die Emissionsschichten EML1, EML2 hinein erfolgt, was eine Verbreiterung der Emissionszone zur Folge hätte oder im ungünstigsten Fall eine Rekombination der Elektronen und der Löcher in der weiteren Emissionsschicht EML2 zu Folge haben könnte, was der beabsichtigten optimierten Weißlichterzeugung entgegenwirken würde.

Eine besonders vorteilhafte Ausgestaltung mit der Elektronenblockschicht 7 sieht vor, dass eine minimale Energie von Singulett-Exzitonen und von Triplett-Exzitonen in der Elektronenblockschicht 7 größer ist als eine minimale Energie von Singulett-Exzitonen und von Triplett-Exzitonen in der Emissionsschicht EML1. Hierdurch wird erreicht, dass die Triplett-Exzitonen, die in der Emissionsschicht EML1 entstehen, nur in Richtung der weiteren Emissionsschicht EML2 diffundieren können, wodurch sich die Effizienz der OLED erhöht. Ist keine Elektronenblockschicht vorgesehen, gilt diese Anforderung an die Exzitonen-Energie für eine vorteilhafte Ausgestaltung der Erfindung sinngemäß für die Löchertransportschicht.

Die Dicke der Emissionsschicht EML1 mit dem / den fluoreszierenden Emitter(n) ist für die erläuterten Beispiele so zu wählen, dass sie größer ist als eine Diffusionslänge der Singulett-Exzitonen, welche zum Beispiel für Alq₃ im Bereich von etwa 20nm liegt, aber kleiner als eine Diffusionslänge der Triplett-Exzitonen, welche zum Beispiel für Alq₃ im Bereich von etwa 140nm liegt (vgl. A. Hunze, Organische Leuchtdioden auf Basis von dotierten Emissionsschichten, Shaker Verlag, 2003). Für andere Materialien sind diese Diffusionslängen natürlich verschieden. Allgemein kann davon ausgegangen werden, dass die Diffusionslänge der Singulett-Exzitonen zwischen etwa 5nm und etwa 30nm liegt. Eine vorteilhafte Ausführungsform sieht deshalb in Abhängigkeit von der verwendeten Fluoreszenzemitterschicht eine Dicke der Emissionsschicht EML1 zwischen etwa 7nm und etwa 35nm vor.

Andererseits soll diese Schicht nicht zu dick werden, da dann ohmsche Verluste größer werden und außerdem zunehmend weniger Triplett-Exzitonen die weitere Emissionsschicht EML2 mit dem / den phosphoreszierenden Emitter(n) erreichen. Daher ist die Emissionsschicht EML1 mit dem / den fluoreszierenden Emittern(n) bevorzugt dünner als etwa 100nm, weiter bevorzugt dünner als etwa 60nm.

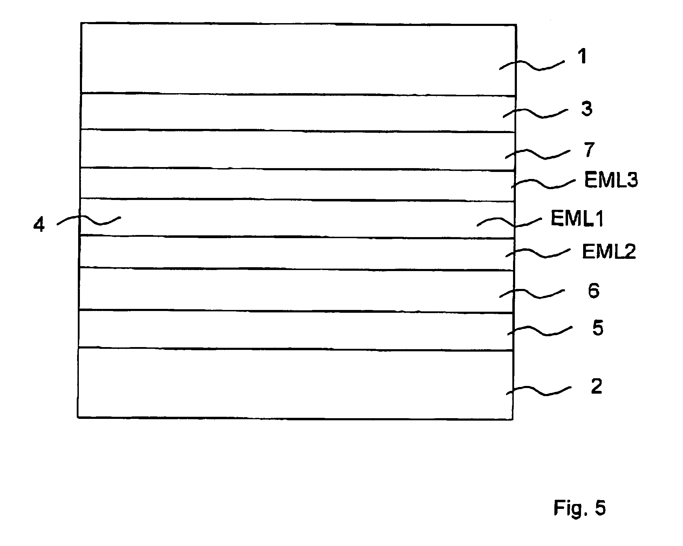

Erfindungsgemäß zeigt Fig. 5 eine OLED, bei der eine Lage der Hauptrekombinationszone dadurch gebildet ist, das die Emissionsschicht EML1 zwischen der weiteren Emissionsschicht EML2 mit dem / den phosphoreszierenden Emitter(n) und einer anderen Emissionsschicht EML3 mit einem oder mehreren phosphoreszierenden Emitter(n) angeordnet ist, wobei die Emissionsschicht EML2 bevorzugt Elektronen und die andere Emissionsschicht EML3 bevorzugt Löcher transportiert. Gegebenenfalls können die beiden Emissionsschichten EML2, EML3 Licht in unterschiedlichen Wellenlängenbereichen emittieren. In diesem Fall ist es notwendig, dass die Emissionsschicht EML1 ein ambipolares Transportverhalten aufweist, das heißt das die Emissionsschicht EML1 sowohl über Elektronentransport- als auch über Löchertransporteigenschaften verfügt, so dass sich die Hauptrekombinationszone nicht an der Grenzfläche einer der beiden Emissionsschichten EML2, EML3 mit der Emissionsschicht EML1 bildet, sondern in der Emissionsschicht EML1. Bei dieser Ausführungsform ist die Dicke der Emissionsschicht EML1 so zu wählen, dass die Dicke größer als etwa die doppelte Diffusionslänge der Singulett-Exzitonen aber kleiner als etwa die doppelte Diffusionslänge der Triplett-Exzitonen ist. Eine vorteilhafte Ausführungsform sieht vor, dass die Dicke der Emissionsschicht EML1 etwa 15nm bis etwa 100nm beträgt.

Nachfolgend werden Berechnungen zur Optimierung der Effizienz hinsichtlich des farblichen Spektrums der beschriebenen Ausführungsformen erläutert.

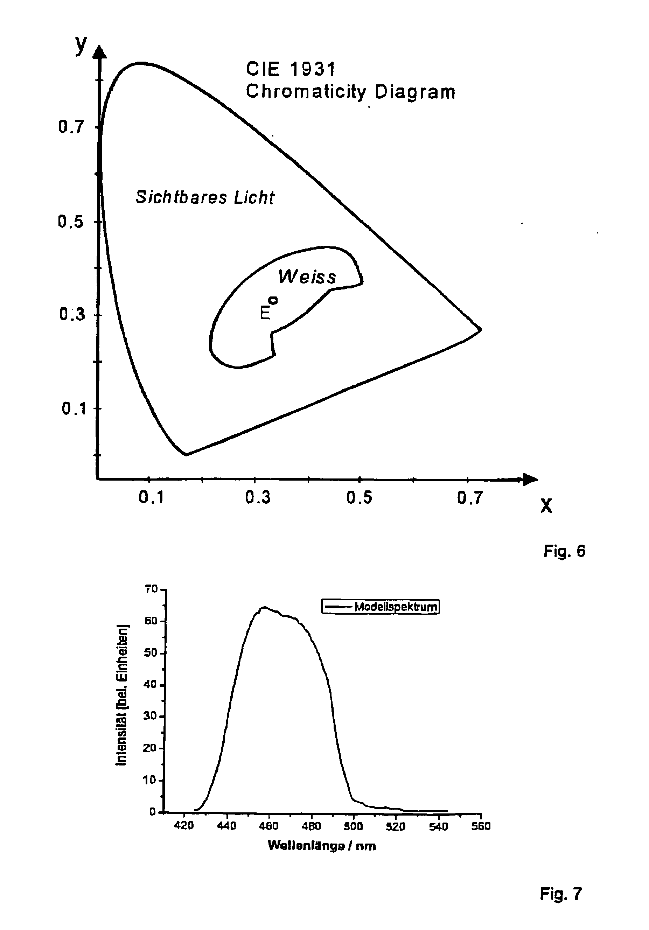

Um eine Weißlichtemission durch mehrere farbige Emitter zu erzielen, ist es notwendig, dass der Anteil der unterschiedlichen Farbkomponenten gut ausbalanciert ist, was bedeutet, dass die Anteile der einzelnen Komponenten zueinander in einem bestimmten, geeigneten Verhältnis stehen müssen. Eine Beschreibung der Güte weißen Lichtes kann mittels der CIE-Farbkoordinaten x und y getroffen werden, welche in dem CIE Farbdiagramm von 1931 beschrieben sind. Ein optimaler Weißton ist hierbei durch die Farbkoordinaten x = 0,33 und y = 0,33 gegeben. Unter einer weißen OLED wird hier eine OLED verstanden, welche Licht emittiert, dessen Farbkoordinate innerhalb des in Fig. 6 dargestellten weißen Bereiches des CIE-Farbdiagramms liegt. Eine Angabe darüber, wieviel Anteile des natürlichen Sonnenspektrums in einer Weißlichtquelle enthalten sind, macht der "Color Rendering Index" (CRI). Bei CRI-Werten von über 65 hat man es bereits mit einem sehr "gesättigten" Weiß zu tun.

Um hohe Effizienzen für den optimalen Farbpunkt von 0,33 / 0,33 zu erzielen, ist es wünschenswert, die einzelnen Emitter-Materialien so zu wählen, dass der Anteil des blauen / blaugrünen Lichts möglichst 25% des gesamten von der OLED emittierten Lichtes beträgt, da in diesem Fall die theoretisch erzielbare interne Quantenausbeute maximal ist. Auf Basis dieser Überlegungen wurden Berechnungen zu den mittels der Erfindung erzielbaren Quantenausbeuten durchgeführt.

Die Berechnungen verwenden unterschiedliche Emitterspektren für rote, grüne und blaue Emission als Grundlage. Für Grün und Rot wurden Elektrolumineszenzspektren von bekannten phosphoreszierenden Emittern verwendet, welche dem Stand der Technik entsprechen ("state of the art" - "SOA"), wohingegen für den im blauen / blaugrünen Spektralbereich emittierenden, fluoreszierenden Emitter neben einem Elektrolumineszenzspektrum eines dem Stand der Technik entsprechenden Fluoreszenzemitters auch ein künstlich generiertes Modellspektrum verwendet wurde, welches in Fig. 7 gezeigt ist.

Basierend auf diesen Spektren und den daraus direkt ableitbaren photometrischen Strahlungsäquivalenten wurde berechnet, welcher Anteil an Lichterzeugung von den einzelnen Emittern benötigt wird, um eine balancierte Weißlichtemission an einem Referenzpunkt mit den CIE-Farbkoordinaten 0,33 / 0,33 zu erzielen. Die Berechnungen wurden mittels einer Software zur Simulation von RGB-Anzeigeelementen durchgeführt. Diese Software ermöglicht die Berechnung des Lichtanteils, welcher von den individuellen Bildpunkten benötigt wird, um eine Farbmischung für einen bestimmten Punkt innerhalb des CIE-Diagramms von 1931 zu erhalten. Die Berechnungen wurden für eine Weißlichterzeugung mittels eines blauen, eines grünen und eines roten Emitters durchgeführt. Diese Überlegungen sind auf die Verwendung eines Emittersystems mit zwei Emittern übertragbar.

Die verwendete Software erlaubt die Berechnung des Stroms welcher von den einzelnen Bildpunkten einer Farbe benötigt wird, sofern die Farbkoordinaten des reinen Emitters sowie seine Stromeffizienz bekannt sind. Zur Verwendung des Programms für die Berechnungen wurden die folgenden Annahmen getroffen. Die Quanteneffizienzen aller Emitter werden als gleich angesehen, sofern ein gleicher Emissionsmechanismus zugrunde liegt, beispielsweise für zwei phosphoreszierende Triplett-Emitter. Darüber hinaus wurde angenommen, dass die Quanteneffizienz eines fluoreszierenden Singulett-Emitters 25% der Quanteneffizienz eines Triplett-Emitters beträgt.

Um in die verwendete Software die Werte für die Stromeffizienz der Emitter einzuspeisen, wurden Werte proportional zu den photometrischen Strahlungsäquivalenten der einzelnen Emitter verwendet. Im Falle von Singulett-Emittern wurden Werte proportional zu 25% des photometrischen Strahlungsäquivalentes verwendet, um der im Vergleich zu Triplett-Emittern verringerten Quanteneffizienz Rechnung zu tragen.

Im vorliegenden Fall ist die Situation jedoch abweichend von den zuvor geschilderten Annahmen, da in diesem Fall für den im blauen Spektralbereich emittierenden Singulett-Emitter 100% der entsprechenden photometrischen Strahlungsäquivalente zur Berechnung verwendet wurden. Diese Annahme kann getroffen werden, da im dargelegten Falle alle Exzitonen in der Emissionsschicht EML1 auf den / dem fluoreszierenden Emitter(n) gebildet werden und die Singulett-Exzitonen dort als Licht emittiert werden. Die Triplett-Exzitonen hingegen diffundieren in die Emissionsschichten EML2 / EML3 mit dem / den Triplett-Emitter(n), wo sie strahlend zerfallen. Aufgrund dieses Umstandes kann ein weißes Emissionssystem in einer organischen Leuchtdiode, welches diesen Mechanismus nutzt, eine maximale theoretische Quanteneffizienz von 100% erreichen, sofern 25% der Lichtemission, welche für die Erzeugung des Weißlichtes benötigt wird, von dem fluoreszierenden blauen Emitter abgestrahlt wird und 75% von den Triplett-Emittern.

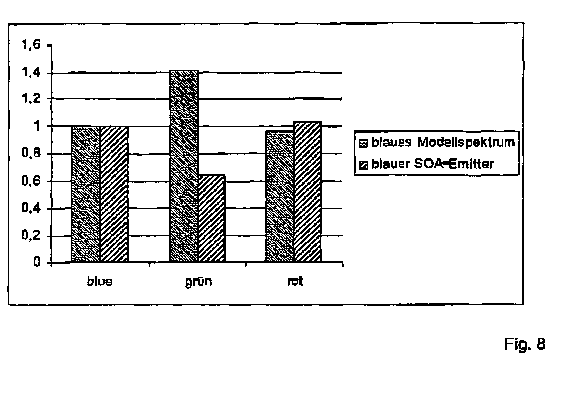

Ein erstes Ziel der Berechnungen war es, zu zeigen, wie eine wohlbalancierte und hocheffiziente Weißlichtemission auf Basis der Erfindung verwirklicht werden kann, sofern ein realistisches blaues Emissionspektrum zugrunde gelegt wird. Diese Berechnungen wurden mit einem blauen Modellspektrum und dem Elektrolumineszenzspektrum eines dem Stand der Technik entsprechenden, blauen Fluoreszenzemitters durchgeführt (vgl. Fig. 8).

Im Fall einer Weißlichtgeneration auf Basis des blauen Modellspektrums werden 28% der Emission von dem fluoreszierenden blauen Emitter benötigt, wohingegen bei Verwendung des bekannten blauen Elektrolumineszenz-Spektrums 37% der gesamten Lichtemission von dem fluoreszierenden blauen Emitter generiert werden müsste. Hieraus ergibt sich, dass die theoretische Effizienz für das betrachtete Modell, verglichen mit einer Effizienz von 100% im Falle einer perfekten Weißlichtemission ausschließlich auf Basis von Triplettemission, im Falle des Modellspektrums 89% beträgt, wohingegen sich dieser Wert im Falle des bekannten blauen Elektrolumineszenz-Spektrums auf 68 % reduziert.

Diese Werte lassen sich nun mit anderen Ansätzen von Weißlicht-OLEDs vergleichen, basierend auf ausschließlich fluoreszierenden Singulett-Emittern oder auf einem blauen Singulett-Emitter und einem roten und grünen Triplett-Emitter; dieser Vergleich ist in Tabelle 1 wiedergegeben.

**Tabelle 1**

| | | **B [%]** | **G [%]** | **R [%]** | **Gesamtes photometrisches Strahlungsäquivalent relativ** | **Gesamteffizienz** |
|---|---|---|---|---|---|---|
| **Ausschließlich Singulett-Emitter** | **Blaues Modellspektrum** | 0,28 | 0,33 | 0,39 | 55,32725 | 25% |
| | **Blaues SOA-EL-Spektrum** | 0,37 | 0,24 | 0,39 | 56,0895 | 25% |
| **Blau Singulett, rot und grün Triplett** | **Blaues Modell** | 0,59 | 0,2 | 0,21 | 129,77375 | 55,80% |
| | **Blaues SOA-EL-Spektrum** | 0,71 | 0,11 | 0,18 | 104,37775 | 46,70% |
| **Ausführungsbeispiel der Erfindung** | **Blaues Modell** | 0,28 | 0,33 | 0,39 | 199,1781 | 89% |
| | **Blaues SOA-EL-Spektrum** | 0,37 | 0,24 | 0,39 | 179,4864 | 68% |
| **Ausschließlich Triplett- Emitter** | **Blaues Modell** | 0,28 | 0,33 | 0,39 | 221,309 | 100% |
| | **Blaues SOA-EL-Spektrum** | 0,37 | 0,24 | 0,39 | 224,358 | 100% |

Die Werte aus der Tabelle 1 belegen, dass die theoretische Grenze einer Weißlichtgeneration auf Basis der Erfindung mindestens 90% beträgt. Im Falle eines noch günstigeren blauen Spektrums kann es gegebenenfalls noch näher an die Obergrenze von 100% heranreichen, welche im Falle einer reinen Lichtgeneration auf Triplett-Emittern erreichbar ist.

Somit kann die interne Quantenausbeute für eine Weißlichtgeneration mittels Elektrolumineszenz bei Verwendung eines fluoreszenten blauen Emitters auf über 65%, in einer verbesserten Ausführung auf über 90% gesteigert werden. Dies bedeutet eine drastische Erhöhung der Exzitonennutzung gegenüber herkömmlichen OLEDs auf Basis eines fluoreszierenden blauen Emitter und phosphoreszierender grüner und roter Emitter und auch gegenüber rein fluoreszierenden weißen OLEDs.

Im folgenden werden zur weiteren Erläuterung Beispiele für OLEDs beschrieben.

Zunächst wurde eine Referenz-OLED mit folgender Schichtanordnung hergestellt:
1) Anode: Indium-Zinn-Oxid (ITO)
2) p-dotierte Löcher-Transportschicht: 80nm 4, 4', 4"-tris(N, N-diphenylamino)triphenylamine (Starburst TDATA) dotiert mit Tetrafluoro-Tetracyano-Quinodimethane (F4-TCNQ)
3) löcherseitige Zwischenschicht: 10nm N,N'-Bis(3-methylphenyl)-N,N'-bis-(phenyl)-benzidine (TPD)
4) blaue Emissionsschicht: 20nm α-NPD
5) elektronenseitige Zwischenschicht: 10nm Bathophenanthrolin (Bphen)
6) n-dotierte Elektronen-Transportschicht: 30nm BPhen dotiert mit Cs
7) Kathode: 100nm Aluminium

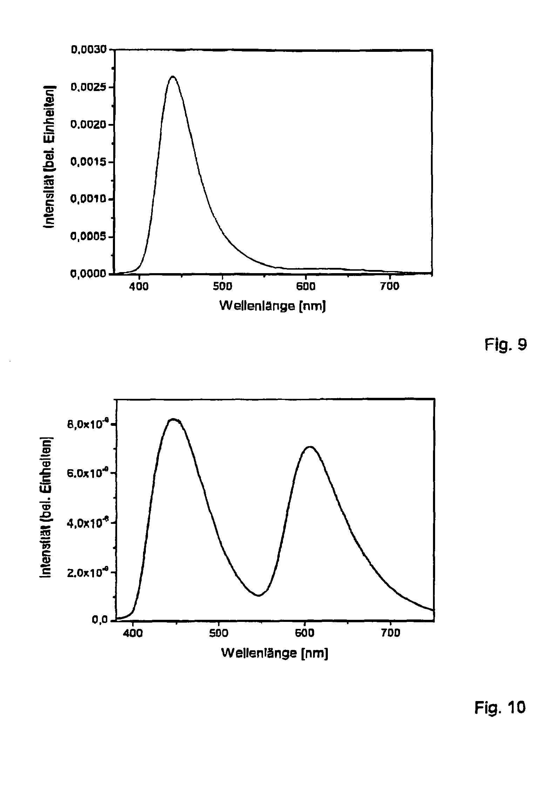

Diese pin-OLED zeigt gemäß Fig. 9 eine blaue Emission mit einem Maximum bei 440nm. Die Probe hat eine Stromeffizienz von 1,8cd/A und eine Quanteneffizienz von 1,5% bei einer Helligkeit von 10000cd/m².

Ein Erläuterungsbeispiel für eine OLED sieht die folgende Schichtstruktur vor (dieses Beispiel fällt nicht in den Umfang der Erfindung):
1) Anode: Indium-Zinn-Oxid (ITO)
2) p-dotierte Löcher-Transportschicht: 80nm 4, 4', 4"-tris(N, N-diphenylamino)triphenylamine (Starburst TDATA) dotiert mit Tetrafluoro-Tetracyano-Quinodimethane (F4-TCNQ)
3) löcherseitige Zwischenschicht: 10nm N,N'-Bis(3-methylphenyl)-N,N'-bis-(phenyl)-benzidine (TPD)
4) orange-rote Emissionsschicht: 10nm Bis[N-(1-naphthyl)-N-phenyl]benzidine (α-NPD) dotiert mit Iridium (III) bis(2-methyldibenzo [f,h]quinoxaline) (acetylacetonate) (RE076, ADS)
5) blaue Emissionsschicht: 20nm α-NPD
6) elektronenseitige Zwischenschicht: 10nm Bathophenanthrolin (Bphen)
7) n-dotierte Elektronen-Transportschicht: 30nm BPhen dotiert mit Cs
8) Kathode: 100nm Aluminium

Diese OLED ist eine weiße pin-OLED, welche bei einer Spannung von 6V eine Helligkeit von über 10000cd/M² zeigt. Das Elektrolumineszenzspektrum hat gemäß Fig. 10 zwei Peaks bei 450nm und 610nm. Die CIE-Farbkoordinaten betragen x = 0,33 und y = 0,22. Die Probe hat eine Stromeffizienz von 5,7cd/A und eine Quanteneffizienz von 4,2% bei einer Helligkeit von 10000cd/m². Bei einer Betrachtung des Elektrolumineszenzspektrum dieser OLED erkennt man deutlich die Emission sowohl von α-NPD als auch die des orange-roten Emitters RE076. Fig. 9 zeigt im Vergleich hierzu das Spektrum einer reinen Emission des α-NPDs.

Aufgrund der energetischen Lage an der Kontaktfläche von BPhen (HOMO ~ -6,4eV, LUMO ~ -3,0eV, He et al., Appl. Phys. Lett. 85(17), 3911 (2004)) und α-NPD (HOMO ~ -5,7eV, LUMO ~ - 2,6eV, Baldo et al., Appl. Phys. Lett. 75(1), 4 (1999)), erfolgt in diesem Aufbau die Rekombination von Löchern und Elektronen notwendigerweise an dieser Kontaktfläche. Daher wird zunächst nur eine blaue Singulett-Emission des α-NPDs erwartet. Tatsächlich zeigt sich jedoch darüber hinaus auch noch eine beträchtliche rote Emission. Ferner zeigt die Probe eine deutlich höhere Strom- und Quanteneffizienz als die Vergleichsprobe ohne die Emissionsschicht mit dem phosphoreszierenden Emitter, was sich in diesem Umfang nur durch eine effiziente Nutzung der an der Grenzfläche BPhen/α-NPD gebildeten Triplett-Exzitonen durch den roten Triplett-Emitter erklären lässt.

Ein bevorzugtes Ausführungsbeispiel für eine erfindungsgemäße OLED sieht die folgende Schichtstruktur vor:
1) Anode: Indium-Zinn-Oxid (ITO)
2) p-dotierte Löcher-Transportschicht: 60nm 4, 4', 4"-tris(N, N-diphenylamino)triphenylamine (Starburst TDATA) dotiert mit Tetrafluoro-Tetracyano-Quinodimethane (F4-TCNQ)
3) löcherseitige Zwischenschicht: 10nm 2,2',7,7'-Tetrakis-(N,N-diphenylamino)-9,9'-spirobifluoren (Spiro-TAD)
4) orange-rote Emissionsschicht: 10nm Bis[N-(1-naphthyl)-N-phenyl]benzidine (α-NPD) dotiert mit Iridium (III) bis(2-methyldibenzo [f,h]quinoxaline) (acetylacetonate) (RE076, ADS)
5) blaue Emissionsschicht: 30nm α-NPD
6) grüne Emissionsschicht: 1,3,5-Tri(phenyl-2-benzimidazole)-benzol (TPBI) dotiert mit fac-Tris(2-phenylpyridine)iridium (Ir(ppy)3)
7) elektronenseitige Zwischenschicht: 10nm Bathophenanthrolin (Bphen)
8) n-dotierte Elektronen-Transportschicht: 30nm BPhen dotiert mit Cs
9) Kathode: 100nm Aluminium

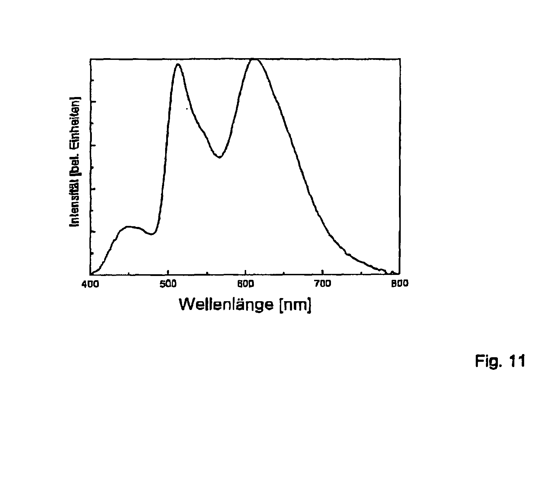

Diese OLED ist eine weiße pin-OLED, welche gemäß Fig. 11 eine Emission mit Farbkoordinaten von 0,42 / 0,44 zeigt. Die Probe weist bei einer Betriebsspannung von 4,3V und einer Helligkeit von 2000cd/m2 eine Stromeffizienz von 11 cd/A auf. Auch bei diesem Aufbau rekombinieren Elektronen und Löcher vorwiegend in der α-NPD-Schicht, zum Teil auch in der Emissionsschicht mit dem grünen Emitter, da α-NPD ein Löcher-Transporter ist (vgl. Kido et al., App. Phys. Lett. 73 (20), 2866 (1998)). Während Singulett-Exzitonen, die im α-NPD gebildet werden, blau strahlend zerfallen, diffundieren die dort generierten Triplett-Exzitonen in die benachbarten Emissionsschichten (orange-rot und grün) und zerfallen dort teilweise strahlend unter Aussendung von Licht längerer Wellenlänge.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Lichtemittierendes Bauelement, insbesondere organische Leuchtdiode, mit einer Elektrode und einer Gegenelektrode und einem zwischen der Elektrode und der Gegenelektrode angeordneten, organischen Bereich mit einem lichtemittierenden organischen Bereich (EM), welcher eine Emissionsschicht (EML1) und eine weitere Emissionsschicht (EML2) umfasst und welcher, beim Anlegen einer elektrischen Spannung an die Elektrode und die Gegenelektrode, Licht in mehreren Farbbereichen im sichtbaren Spektralbereich emittierend gebildet ist, wahlweise bis hin zu Weißlicht, wobei:
- die Emissionsschicht (EML1) einen überwiegend im blauen oder im blaugrünen Spektralbereich Licht emittierenden, fluoreszierenden Emitter umfasst;
- die weitere Emissionsschicht (EML2) einen oder mehrere überwiegend im nicht-blauen Spektralbereich Licht emittierende, phosphoreszierende Emitter umfasst;
- eine Triplettenergie für ein Energieniveau eines Triplettzustandes des fluoreszierenden Emitters in der Emissionsschicht (EML1) größer als eine Triplettenergie für ein Energieniveau eines Triplettzustandes des phosphoreszierenden Emitters in der weiteren Emissionsschicht (EML2) ist; und
- der lichtemittierende organische Bereich einen mindestens 5%-igen Anteil des erzeugten Lichtes im sichtbaren Spektralbereich als Fluoreszenzlicht von Singulettzuständen des fluoreszierenden Emitters in der Emissionsschicht (EML1) abgebend gebildet ist; **gekennzeichnet durch** die folgenden Merkmale:
- der lichtemittierende organische Bereich (EM) umfasst eine andere Emissionsschicht (EML3) mit einem oder mehreren überwiegend im nicht-blauen Spektralbereich Licht emittierenden, phosphoreszierenden Emittern;
- die Emissionsschicht (EML1) ist zwischen der weiteren Emissionsschicht (EML2) und der anderen Emissionsschicht (EML3) angeordnet;
- die Emissionsschicht (EML1) weist ein ambipolares Transportverhalten auf;
- die Dicke der Emissionsschicht (EML1) ist größer als die doppelte Diffusionslänge der Singulett-Exzitonen aber kleiner als die doppelte Diffusionslänge der Triplett-Exzitonen;
- die weitere Emissionsschicht (EML2) ist elektronentransportierend, wobei ein Abstand zwischen einer der Kathode zugewandten Oberfläche der weiteren Emissionsschicht (EML2) und einer der weiteren Emissionsschicht (EML2) zugewandten Oberfläche der Kathode kleiner als ein Abstand zwischen einer der Kathode zugewandten Oberfläche der Emissionsschicht (EML1) und einer der Emissionsschicht (EML1) zugewandten Oberfläche der Kathode sowie ein Abstand zwischen einer der Kathode zugewandten Oberfläche der anderen Emissionsschicht (EML3) und einer der anderen Emissionsschicht (EML3) zugewandten Oberfläche der Kathode ist; und
- die andere Emissionsschicht (EML3) ist löchertransportierend, wobei ein Abstand zwischen einer der Anode zugewandten Oberfläche der anderen Emissionsschicht (EML3) und einer der anderen Emissionsschicht (EML3) zugewandten Oberfläche der Anode kleiner als ein Abstand zwischen einer der Anode zugewandten Oberfläche der Emissionsschicht (EML1) und einer der Emissionsschicht (EML1) zugewandten Oberfläche der Anode sowie ein Abstand zwischen einer der Anode zugewandten Oberfläche der weiteren Emissionsschicht (EML2) und einer der weiteren Emissionsschicht (EML2) zugewandten Oberfläche der Anode ist.

2. Lichtemittierendes Bauelement nach Anspruch 1, **dadurch gekennzeichnet, dass** die Emissionsschicht (EML1) und die weitere Emissionsschicht (EML2) aneinandergrenzend gebildet sind.

3. Lichtemittierendes Bauelement nach Anspruch 1 oder 2, **dadurch gekennzeichnet, dass** die Emissionsschicht (EML1) und / oder die weitere Emissionsschicht (EML2) und / oder die andere Emissionsschicht (EML3) mehrschichtig gebildet sind.

4. Lichtemittierendes Bauelement nach einem der vorangehenden Ansprüche, **dadurch gekennzeichnet, dass** die Emissionsschicht (EML1) eine Dicke zwischen etwa 5nm und etwa 50nm aufweist.

5. Lichtemittierendes Bauelement nach einem der vorangehenden Ansprüche, **dadurch gekennzeichnet, dass** der lichtemittierende organische Bereich (EM) Weißlicht emittierend gebildet ist, wobei der oder alle phosphoreszierenden Emitter in der weiteren Emissionsschicht (EML2) im roten, im orangen oder im gelben Spektralbereich Licht emittierende Emitter sind.

6. Lichtemittierendes Bauelement nach einem der Ansprüche 1 bis 4, **dadurch gekennzeichnet, dass** der lichtemittierende organische Bereich (EM) Weißlicht emittierend gebildet ist, wobei der oder alle phosphoreszierenden Emitter in der weiteren Emissionsschicht (EML2) im roten, im orangen oder im grünen Spektralbereich Licht emittierende Emitter sind.

7. Lichtemittierendes Bauelement nach einem der vorangehenden Ansprüche, **dadurch gekennzeichnet, dass** der lichtemittierende organische Bereich (EM) Weißlicht emittierend gebildet ist, wobei der oder alle phosphoreszierenden Emitter in der anderen Emissionsschicht (EML3) im roten, im orangen oder im gelben Spektralbereich Licht emittierende Emitter sind.

8. Lichtemittierendes Bauelement nach einem der Ansprüche 1 bis 6, **dadurch gekennzeichnet, dass** der lichtemittierende organische Bereich (EM) Weißlicht emittierend gebildet ist, wobei der oder alle phosphoreszierenden Emitter in der anderen Emissionsschicht (EML3) im roten, im orangen oder im grünen Spektralbereich Licht emittierende Emitter sind.

9. Lichtemittierendes Bauelement nach einem der vorangehenden Ansprüche, **dadurch gekennzeichnet, dass** zwischen dem organischen lichtemittierenden Bereich (EM) und der Elektrode und /oder zwischen dem organischen lichtemittierenden Bereich (EM) und der Gegenelektrode eine jeweilige dotierte organische Schicht gebildet ist.

10. Lichtemittierendes Bauelement nach Anspruch 9, **dadurch gekennzeichnet, dass** die jeweilige dotierte organische Schicht eine mit einem Akzeptor-Material p-dotierte Schicht oder eine mit einem Donator-Material n-dotierte Schicht ist.

11. Lichtemittierendes Bauelement nach einem der vorangehenden Ansprüche, **dadurch gekennzeichnet, dass** der fluoreszierende Emitter in der Emissionsschicht (EML1) eine metall-organische Verbindung oder eine Komplexverbindung mit einem Metall mit einer Ordnungszahl kleiner als 40 ist.

12. Lichtemittierendes Bauelement nach einem der Ansprüche 1 bis 10, **dadurch gekennzeichnet, dass** der fluoreszierende Emitter in der Emissionsschicht (EML1) einen elektronenziehenden Substituenten aus einer der folgenden Klassen umfasst:
a) Halogene wie Fluor, Chlor, Iod oder Brom;
b) CN;
c) halogenierte oder cyanosubstituierte Alkane oder Alkene, insbesondere Trifluormethyl, Pentafluorethyl, Cyanovinyl, Dicyanovinyl, Tricyanovinyl;
d) halogenierte oder cyanosubstituierte Arylreste, insbesondere Pentafluorphenyl; oder
e) Borylreste, insbesondere Dialkyl-boryl, Dialkyl-boryl mit Substituenten an den Alkylgruppen, Diaryl-boryl oder Diaryl-boryl mit Substituenten an den Arylgruppen.

13. Lichtemittierendes Bauelement nach einem der Ansprüche 1 bis 10, **dadurch gekennzeichnet, dass** der fluoreszierende Emitter in der Emissionsschicht (EML1) einen elektronenschiebenden Substituenten einer der folgenden Klassen umfasst:
a) Alkylreste wie Methyl, Ethyl, Tertiärbutyl, Isopropyl;
b) Alkoxyreste;
c) Arylreste mit oder ohne Substituenten am Aryl, insbesondere Tolyl und Mesithyl; oder
d) Aminogruppen, insbesondere NH2, Dialkylamin, Diarylamin und Diarylamin mit Substituenten am Aryl.

14. Lichtemittierendes Bauelement nach einem der Ansprüche 1 bis 10, **dadurch gekennzeichnet, dass** der fluoreszierende Emitter in der Emissionsschicht (EML1) eine funktionale Gruppe mit einer Elektronen-Akzeptor-Eigenschaft aus einer der folgenden Klassen umfasst:
a) Oxadiazol
b) Triazol
c) Benzothiadiazole
d) Benzimidazole und N-Aryl-Benzimidazole
e) Bipyridin
f) Cyanovinyl
g) Quinoline
h) Quinoxaline
i) Triarylboryl
j) Silol-Einheiten, insbesondere Derivat-Gruppen von Silacyclopentadien
k) Cyclooctatetraen
l) Chinoide Strukturen und Ketone, incl. chinoide Thiophen-Derivate
m) Pyrazoline
n) Pentaaryl-Cyclopentadien
o) Benzothiadiazole
p) Oligo-Para-Phenyl mit elektronenziehenden Substituenten oder
q) Fluorene und Spiro-Bifluorene mit elektronenziehenden Substituenten.

15. Lichtemittierendes Bauelement nach einem der Ansprüche 1 bis 10, **dadurch gekennzeichnet, dass** der fluoreszierende Emitter in der Emissionsschicht (EML1) eine funktionale Gruppe mit einer Elektronen-Akzeptor-Eigenschaft aus einer der folgenden Klassen umfasst:
a) Triarylamine
b) Oligo-Para-Phenyl oder Oligo-Meta-Phenyl
c) Carbazole
d) Fluoren oder Spiro-Bifluorene
e) Phenylen-Vinylen-Einheiten
f) Naphthalen
g) Anthrazen
h) Perylen
i) Pyren oder
j) Thiophen.

## Claims

1. Light-emitting component, in particular organic light-emitting diode, having an electrode and a counterelectrode and an organic region - arranged between the electrode and the counterelectrode - with a light-emitting organic region (EM), which comprises an emission layer (EML1) and a further emission layer (EML2) and which, upon application of an electrical voltage to the electrode and the counterelectrode, is formed in a manner emitting light in a plurality of colour ranges in the visible spectral range, optionally through to white light, in which case:
- the emission layer (EML1) comprises a fluorescent emitter which emits light predominantly in the blue or in the blue-green spectral range;
- the further emission layer (EML2) comprises one or a plurality of phosphorescent emitters emitting light predominantly in the non-blue spectral range;
- a triplet energy for an energy level of a triplet state of the fluorescent emitter in the emission layer (EML1) is greater than a triplet energy for an energy level of a triplet state of the phosphorescent emitter in the further emission layer (EML2); and
- the light-emitting organic region is formed to deliver an at least 5% proportion of the light generated in the visible spectral range as fluorescent light from singlet states of the fluorescent emitter in the emission layer (EML1), **characterized by** the following features:
- the light-emitting organic region (EM) comprises another emission layer (EML3) having one or a plurality of phosphorescent emitters emitting light predominantly in the non-blue spectral range;
- the emission layer (EML1) is arranged between the further emission layer (EML2) and the other emission layer (EML3);
- the emission layer (EML1) comprises an ambipolar transport behaviour;
- the thickness of the emission layer (EML1) is greater than twice the diffusion length of the singlet excitons but less than twice the diffusion length of the triplet excitons;
- the further emission layer (EML2) transports electrons, a distance between a surface of the further emission layer (EML2) which faces the cathode and a surface of the cathode which faces the further emission layer (EML2) being less than a distance between a surface of the emission layer (EML1) which faces the cathode and a surface of the cathode which faces the emission layer (EML1), and also a distance between a surface of the other emission layer (EML3) which faces the cathode and a surface of the cathode which faces the other emission layer (EML3); and
- the other emission layer (EML3) transports holes, a distance between a surface of the other emission layer (EML3) which faces the anode and a surface of the anode which faces the other emission layer (EML3) being less than a distance between a surface of the emission layer (EML1) which faces the anode and a surface of the anode which faces the emission layer (EML1), and also a distance between a surface of the further emission layer (EML2) which faces the anode and a surface of the anode which faces the further emission layer (EML2).

2. Light-emitting component according to claim 1, **characterized in that** the emission layer (EML1) and the further emission layer (EML2) are formed in a manner adjoining one another.

3. Light-emitting component according to claim 1 or 2, **characterized in that** the emission layer (EML1) and/or the further emission layer (EML2) and/or the other emission layer (EML3) are formed in multilayer fashion.

4. Light-emitting component according to one of the preceding claims, **characterized in that** the emission layer (EML1) has a thickness of between approximately 5 nm and approximately 50 nm.

5. Light-emitting component according to one of the preceding claims, **characterized in that** the light-emitting organic region (EM) is formed in a manner emitting white light, the or all of the phosphorescent emitters in the further emission layer (EML2) being emitters emitting light in the red, orange or yellow spectral range.

6. Light-emitting component according to one of Claims 1 to 4, **characterized in that** the light-emitting organic region (EM) is formed in a manner emitting white light, the or all of the phosphorescent emitters in the further emission layer (EML2) being emitters emitting light in the red, orange or green spectral range.

7. Light-emitting component according to one of the preceding claims, **characterized in that** the light-emitting organic region (EM) is formed in a manner emitting white light, the or all of the phosphorescent emitters in the other emission layer (EML3) being emitters emitting light in the red, orange or yellow spectral range.

8. Light-emitting component according to one of Claims 1 to 6, **characterized in that** the light-emitting organic region (EM) is formed in a manner emitting white light, the or all of the phosphorescent emitters in the other emission layer (EML3) being emitters emitting light in the red, orange or green spectral range.

9. Light-emitting component according to one of the preceding claims, **characterized in that** a respective doped organic layer is formed between the organic light-emitting region (EM) and the electrode and/or between the organic light-emitting region (EM) and the counterelectrode.

10. Light-emitting component according to Claim 9, **characterized in that** the respective doped organic layer is a layer which is p-doped with an acceptor material or a layer which is n-doped with a donor material.

11. Light-emitting component according to one of the preceding claims, **characterized in that** the fluorescent emitter in the emission layer (EML1) is an organometallic compound or a complex compound with a metal having an ordinal number of less than 40.

12. Light-emitting component according to one of Claims 1 to 10, **characterized in that** the fluorescent emitter in the emission layer (EML1) comprises an electron-attracting substituent from one of the following classes:
a) halogens such as fluorine, chlorine, iodine or bromine;
b) CN;
c) halogenated or cyano-substituted alkanes or alkenes, in particular trifluoromethyl, pentafluoroethyl, cyanovinyl, dicyanovinyl, tricyanovinyl;
d) halogenated or cyano-substituted aryl radicals, in particular pentafluorophenyl; or
e) boryl radicals, in particular dialkylboryl, dialkylboryl having substituents on the alkyl groups, diarylboryl or diarylboryl having substituents on the aryl groups.

13. Light-emitting component according to one of Claims 1 to 10, **characterized in that** the fluorescent emitter in the emission layer (EML1) comprises an electron-donating substituent of one of the following classes:
a) alkyl radicals such as methyl, ethyl, tert-butyl, isopropyl;
b) alkoxy radicals;
c) aryl radicals with or without substituents on the aryl, in particular tolyl and mesityl; or
d) amino groups, in particular NH2, dialkylamine, diarylamine and diarylamine having substituents on the aryl.

14. Light-emitting component according to one of Claims 1 to 10, **characterized in that** the fluorescent emitter in the emission layer (EML1) comprises a functional group having an electron acceptor property from one of the following classes:
a) oxadiazole
b) triazole
c) benzothiadiazoles
d) benzimidazoles and N-aryl-benzimidazoles
e) bipyridine
f) cyanovinyl
g) quinolines
h) quinoxalines
i) triarylboryl
j) silol units, in particular derivative groups of silacyclopentadiene
k) cyclooctatetraene
l) quinoid structures and ketones, including quinoid thiophene derivatives
m) pyrazolines
n) pentaaryl cyclopentadiene
o) benzothiadiazoles
p) oligo-para-phenyl with electron-attracting substituents, or
q) fluorenes and spiro-bifluorenes with electron-attracting substituents.

15. Light-emitting component according to one of Claims 1 to 10, **characterized in that** the fluorescent emitter in the emission layer (EML1) comprises a functional group having an electron acceptor property from one of the following classes:
a) triarylamines
b) oligo-para-phenyl or oligo-meta-phenyl
c) carbazoles
d) fluorene or spiro-bifluorenes
e) phenylene-vinylene units
f) naphthalene
g) anthracene
h) perylene
i) pyrene or
j) thiophene.

## Revendications

1. Composant électroluminescent, en particulier diode électroluminescente organique, avec une électrode et une contre-électrode et une zone organique disposée entre l'électrode et la contre-électrode avec une zone organique électroluminescente (EM) qui comprend une couche émettrice (EML1) et une autre couche émettrice (EML2) et qui, lorsqu'on applique une tension électrique à l'électrode et la contre-électrode, est formée de manière à émettre de la lumière en plusieurs zones chromatiques dans la plage spectrale visible, facultativement jusqu'à une lumière blanche, étant donné que :
- la couche émettrice (EML1) comprend un émetteur fluorescent qui émet de la lumière principalement dans la plage spectrale bleue ou dans la plage spectrale bleu vert ;
- l'autre couche émettrice (EML2) comprend un ou plusieurs émetteurs phosphorescents qui émettent de la lumière principalement dans la plage spectrale non bleue ;
- une énergie de triplet pour un niveau d'énergie d'un état de triplet de l'émetteur fluorescent dans la couche émettrice (EML1) est plus grande qu'une de triplet pour un niveau d'énergie d'un état de triplet de l'émetteur phosphorescent dans la couche émettrice (EML2) ; et
- la zone organique électroluminescente est formée de manière à émettre une part d'au moins 5 % de la lumière générée dans la plage spectrale visible comme lumière fluorescente d'états singulets de l'émetteur fluorescent dans la couche émettrice (EML1);
**caractérisé par** les caractéristiques suivantes:
- la zone organique électroluminescente (EM) comprend une autre couche émettrice (EML3) avec un ou plusieurs émetteurs phosphorescents qui émettent de la lumière principalement dans la plage spectrale non bleue ;
- la couche émettrice (EML1) est disposée entre l'autre couche émettrice (EML2) et l'autre couche émettrice (EML3) ;
- la couche émettrice (EML1) présente un comportement de transport ambipolaire ;
- l'épaisseur de la couche émettrice (EML1) est supérieure au double de la longueur de diffusion des excitons singulets, mais inférieure au double de la longueur de diffusion des excitons de triplet ;
- l'autre couche émettrice (EML2) transporte des électrons, étant donné qu'un écartement entre une surface orientée vers la cathode de l'autre couche émettrice (EML2) et une surface orientée vers l'autre couche émettrice (EML2) de la cathode est plus petit qu'un écartement entre une surface orientée vers la cathode de la couche émettrice (EML1) et une surface orientée vers la couche émettrice (EML1) de la cathode ainsi qu'un écartement entre une surface orientée vers la cathode de l'autre couche émettrice (EML3) et une surface orientée vers l'autre couche émettrice (EML3) de la cathode ; et
- l'autre couche émettrice (EML3) transporte des trous, étant donné qu'un écartement entre une surface orientée vers l'anode de l'autre couche émettrice (EML3) et une surface orientée vers l'autre couche émettrice (EML3) de l'anode est plus petit qu'un écartement entre une surface orientée vers l'anode de la couche émettrice (EML1) et une surface orientée vers la couche émettrice (EML1) de l'anode ainsi qu'un écartement entre une surface orientée vers l'anode de l'autre couche émettrice (EML2) et une surface orientée vers l'autre couche émettrice (EML2) de l'anode.

2. Composant électroluminescent selon la revendication 1, **caractérisé en ce que** la couche émettrice (EML1) et l'autre couche émettrice (EML2) sont formées de manière à être adjacentes.

3. Composant électroluminescent selon la revendication 1 ou 2, **caractérisé en ce que** la couche émettrice (EML1) et/ou l'autre couche émettrice (EML2) et/ou l'autre couche émettrice (EML3) sont formées comme multicouches.

4. Composant électroluminescent selon l'une quelconque des revendications précédentes, **caractérisé en ce que** la couche émettrice (EML1) présente une épaisseur entre 5 nm et environ 50 nm.

5. Composant électroluminescent selon l'une quelconque des revendications précédentes, **caractérisé en ce que** la zone organique électroluminescente (EM) est formée de manière à émettre de la lumière blanche, étant donné que l'émetteur ou tous les émetteurs phosphorescents dans l'autre couche émettrice (EML2) sont des émetteurs qui émettent de la lumière dans la plage spectrale rouge, dans la plage spectrale orange ou dans la plage spectrale jaune.

6. Composant électroluminescent selon l'une quelconque des revendications 1 à 4, **caractérisé en ce que** la zone organique électroluminescente (EM) est formée de manière à émettre de la lumière blanche, étant donné que l'émetteur ou tous les émetteurs phosphorescents dans l'autre couche émettrice (EML2) sont des émetteurs qui émettent de la lumière dans la plage spectrale rouge, dans la plage spectrale orange ou dans la plage spectrale verte.

7. Composant électroluminescent selon l'une quelconque des revendications précédentes, **caractérisé en ce que** la zone organique électroluminescente (EM) est formée de manière à émettre de la lumière blanche, étant donné que l'émetteur ou tous les émetteurs phosphorescents dans l'autre couche émettrice (EML3) sont des émetteurs qui émettent de la lumière dans la plage spectrale rouge, dans la plage spectrale orange ou dans la plage spectrale jaune.

8. Composant électroluminescent selon l'une quelconque des revendications 1 à 6, **caractérisé en ce que** la zone organique électroluminescente (EM) est formée de manière à émettre de la lumière blanche, étant donné que l'émetteur ou tous les émetteurs phosphorescents dans l'autre couche émettrice (EML3) sont des émetteurs qui émettent de la lumière dans la plage spectrale rouge, dans la plage spectrale orange ou dans la plage spectrale verte.

9. Composant électroluminescent selon l'une quelconque des revendications précédentes, **caractérisé en ce qu'**est formée chaque fois entre la zone organique électroluminescente (EM) et l'électrode et/ou entre la zone organique électroluminescente (EM) et la contre-électrode une couche organique dopée.

10. Composant électroluminescent selon la revendication 9, **caractérisé en ce que** chaque couche organique dopée est une couche dopée de type p avec un matériau accepteur ou une couche dopée de type n avec un matériau donateur.

11. Composant électroluminescent selon l'une quelconque des revendications précédentes, **caractérisé en ce que** l'émetteur fluorescent dans la couche émettrice (EML1) est un composé métallo-organique ou un composé complexe avec un métal dont le nombre atomique est inférieur à 40.

12. Composant électroluminescent selon l'une quelconque des revendications 1 à 10, **caractérisé en ce que** l'émetteur fluorescent dans la couche émettrice (EML1) comprend un substituant extracteur d'électrons choisi parmi l'une des classes suivantes :
a) halogènes comme le fluor, le chlore, l'iode ou le brome;
b) CN;
c) alcanes ou alcènes halogénés ou cyanosubstitués, en particulier le trifluorométhyle, le pentafluoroéthyle, le cyanovinyle, le dicyanoviniyle, le tricyanovinyle ;
d) restes d'aryle halogénés ou cyanosubstitués, en particulier le pentafluorophényle ; ou
e) restes de boryle, en particulier le dialkylboryle, le dialkylboryle avec substituants sur les groupes d'alkyle, le diarylboryle ou le diarylboryle avec substituants sur les groupes d'alkyle.

13. Composant électroluminescent selon l'une quelconque des revendications 1 à 10, **caractérisé en ce que** l'émetteur fluorescent dans la couche émettrice (EML1) comprend un substituant pousseur d'électrons choisi parmi l'une des classes suivantes :
a) restes d'alkyle comme le méthyle, l'éthyle, le butyle tertiaire, l'isopropyle ;
b) restes d'alcoxyle ;
c) restes d'aryle avec ou sans substituants sur l'aryle, en particulier le tolyle et le mésithyle ; ou
d) groupes amino, en particulier le NH2, la dialkylamine, la diarylamine et la diarylamine avec substituants sur l'aryle.

14. Composant électroluminescent selon l'une quelconque des revendications 1 à 10, **caractérisé en ce que** l'émetteur fluorescent dans la couche émettrice (EML1) comprend un groupe fonctionnel avec une propriété d'accepteur d'électrons choisi parmi l'une des classes suivantes :
a) oxadiazole
b) triazole
c) benzothiadiazoles
d) benzimidazoles et N-axyl-benzimidazoles
e) bipyridine
f) cyanovinyle
g) quinoline
h) quinoxaline
i) triarylboryle
j) unités de silole, en particulier groupes de dérivés de silacyclopentadiène
k) cyclooctatétraène
l) structures quinoïdes et cétone, y compris dérivés de thiophène quinoïdes
m) pyrazoline
n) pentaaryl-cyclopentadiène
o) benzothiadiazoles
p) oligo-para-phényle avec substituants extracteurs d'électrons, ou
q) fluorènes et spiro-bifluorènes avec substituants extracteurs d'électrons.

15. Composant électroluminescent selon l'une quelconque des revendications 1 à 10, **caractérisé en ce que** l'émetteur fluorescent dans la couche émettrice (EML1) comprend un groupe fonctionnel avec une propriété d'accepteur d'électrons choisi parmi l'une des classes suivantes :
a) triarylamines
b) oligo-para-phényle ou oligo-méta-phényle
c) carbazoles
d) fluorènes ou spiro-bifluorènes
e) unités de phénylène-vinylène
f) naphthalène
g) anthrazène
h) pérylène
i) pyrène ou
j) thiophène.
